# EUROPÄISCHE PATENTSCHRIFT

(11) **EP 2 742 642 B1**
(45) Veröffentlichungstag und Bekanntmachung des Hinweises auf die Patenterteilung: **12.04.2017**
(21) Anmeldenummer: 11784926.5
(22) Anmeldetag: 11.08.2011
(51) Int. Cl.: H04L 7/00, G08C 19/28, H04L 25/45, H03K 3/3562, H04L 1/00

(54) **MESSWERT-ÜBERTRAGUNGSVORRICHTUNG**
MEASURED VALUE TRANSMITTING DEVICE
DISPOSITIF DE TRANSMISSION DE VALEURS DE MESURE

(43) Veröffentlichungstag der Anmeldung: 18.06.2014
(73) Patentinhaber: Balluff GmbH, 73765 Neuhausen a.d.F. (DE)
(72) Erfinder: HAHN, Uwe, 73732 Esslingen (DE)
(74) Vertreter: Jakelski & Althoff Patentanwälte PartG mbB
(86) Internationale Anmeldenummer: PCT/DE2011/001576
(87) Internationale Veröffentlichungsnummer: WO 2013/020529

(56) Entgegenhaltungen:
- EP-A1- 0 171 579
- US-A1- 2003 053 547
- US-A1- 2005 001 488
- OUDJIDA A K ET AL: "Design and test of general-purpose SPI Master/Slave IPs on OPB bus", SYSTEMS SIGNALS AND DEVICES (SSD), 2010 7TH INTERNATIONAL MULTI-CONFERENCE ON, IEEE, PISCATAWAY, NJ, USA, 27. Juni 2010 (2010-06-27), Seiten 1-6, XP031763386, ISBN: 978-1-4244-7532-2
- TEXAS INSTRUMENTS: "TMS320x281x, 280x DSP Serial Peripheral Interface (SPI) Reference Guide", INTERNET CITATION, November 2004 (2004-11), XP002369243, Gefunden im Internet: URL:http://focus.ti.com/lit/ug/spru059b/sp ru059b.pdf [gefunden am 2006-02-22]

## Beschreibung

Die Erfindung geht aus von einer Messwert-Übertragungsvorrichtung mit einer seriellen Datenübertragung zwischen einem Slave und einem Master gemäß dem SSI-Verfahren (Synchronous Serial Interface), bei welcher ein von einem Sensor erfasster Messwert in einem dem Sensor zugeordneten Slave aufbereitet sowie in einen seriellen Datenstrom umgesetzt und zu einem Master übertragen wird, der die erfassten Messwerte verarbeitet.

Eine derartige Messwert-Übertragungsvorrichtung, die aufgrund ihrer Arbeitsweise als "Synchronous Serial Interface (SSI)" bezeichnet wird, ist in der Offenlegungsschrift EP 171 579 A1 beschrieben. Die Messwert-Übertragungsvorrichtung enthält einen Master sowie mindestens einen Slave. Die Slaves sind den Sensoren zugeordnet, wobei einem Slave gegebenenfalls mehrere Sensoren zugeordnet sein können. Die von einem Sensor erfassten Messwerte werden vom Sensor bereits in digitaler Form als Datenbits bereitgestellt. Die Datenbits werden im Slave im Rahmen eines Parallelbetriebs laufend in ein Schieberegister geladen. Das Schieberegister kann die Datenbits des Messwerts im Parallelbetrieb speichern und anschließend in einem Seriellbetrieb zur seriellen Datenübertragung bereitstellen. Während des Parallelbetriebs können in Abhängigkeit von der Anlieferungsrate der Messwerte beziehungsweise Datenbits vom Sensor zahlreiche Messwerte im Schieberegister hinterlegt und wieder durch aktuellere, neu erfasste Messwerte ersetzt werden, ohne dass ein Messwert gespeichert und seriell zum Master übertragen wird.

Der Master, in welchem die Verarbeitung und Bewertung der die Messwerte widerspiegelnden Datenbits stattfindet, fordert die Datenbits eines Messwerts im Rahmen eines Taktbursts von einem ausgewählten Slave an. Der Taktburst weist eine festgelegte Anzahl von Taktzyklen auf. Die Anzahl der Taktzyklen ist sowohl dem Slave als auch dem Master bekannt. Die erste vom Slave erkannte vorgegebene Taktflanke, beispielsweise die erste fallende Taktflanke, triggert eine monostabile Kippstufe, deren Ausgangssignal das Schieberegister vom Parallelbetrieb in den Seriellbetrieb umschaltet. Gleichzeitig werden mit der ersten Taktflanke die parallel anliegenden Datenbits eines Messwerts, welche den erfassten Messwert zu diesem Zeitpunkt widerspiegeln, im Schieberegister gespeichert und zur seriellen Datenübertragung bereitgestellt.

Mit jeder weiteren vorgegebenen Taktflanke, beispielsweise jeder fallenden Taktflanke, wird ein Datenbit des Messwerts vom Slave zum Master übertragen. Weiterhin (re)triggert jede fallende Taktflanke die monostabile Kippstufe. Die Anzahl der Taktzyklen ist genau auf die Anzahl der zu übertragenden Datenbits abgestimmt. Für eine Anzahl von n zu übertragenden Datenbits werden n+1 Taktzyklen vom Master innerhalb eines Taktbursts ausgegeben.

Nach der Übertragung des letzten Datenbits des Messwerts sorgt das Ausgangssignal der monostabilen Kippstufe noch bis zum Ablauf der von der retriggerbaren monostabilen Kippstufe vorgegebenen Zeit dafür, dass die Datenleitung auf einem vorgegebenen Datensignalpegel gehalten wird, indem das Schieberegister noch für die Monoflop-Zeit im Seriellbetrieb verbleibt. Damit wird eine Wartezeit definiert. Der Master erkennt den vom Slave während der Wartezeit gehaltenen Datensignalpegel und fordert erst nach Ablauf der Wartezeit den betreffenden Slave zur Übertragung der Datenbits eines neuen Messwerts auf.

In der Offenlegungsschrift DE 101 13 716 A1 ist eine serielle Kommunikation mit einer Start/Stopp-Schnittstelle beschrieben, welche einen Positions- oder Geschwindigkeitssensor, dem ein Slave zugeordnet ist, mit einem Master verbindet.

In der Offenlegungsschrift EP 1 294 119 A1 ist eine Schnittstelle zur seriellen Übertragung von Messwerten beschrieben, bei der den Datenbits Prüfbits angehängt werden, die sich aus einer zyklischen Redundanzprüfung ergeben. Das bekannte Verfahren wird auch als "Cyclic Redundancy Check" (CRC-Verfahren) bezeichnet.

Bei dem CRC-Verfahren handelt es sich um eine Vorgehensweise, bei dem die von einer Datenquelle bereitgestellten seriellen Datenbits als ein Polynom betrachtet werden und durch ein vorgegebenes Generatorpolynom dividiert werden, um dann den entstehenden Rest der Division als an die Datenbits angehängte Prüfbits zum Datenempfänger zu senden. Im Empfänger wird dieselbe Division durch das Generatorpolynom mit sämtlichen empfangenen Bits, also den Datenbits und den Prüfbits durchgeführt. Aufgrund der Einbeziehung der übertragenen Prüfbits in die Division muss sich bei einer korrekten Übertragung der Wert null ohne Rest ergeben. Nur dann wurden die Bits richtig übertragen. Das CRC-Verfahren ist beispielsweise unter der Internet-Adresse http://de.wikipedia.org/wiki/Zyklische_Redundanzprüfung
ausführlich beschrieben.

Der Erfindung liegt die Aufgabe zugrunde, Messwert-Übertragungsvorrichtungen mit einer seriellen Datenübertragung zwischen einem Slave und einem Master gemäß dem SSI-Verfahren anzugeben, die eine hohe Datensicherheit aufweisen.

Die Aufgabe wird durch die in den nebengeordneten unabhängigen Ansprüchen angegebenen Merkmale jeweils gelöst.

### Offenbarung der Erfindung

Die erfindungsgemäße Messwert-Übertragungsvorrichtung gemäß einer ersten Ausführung geht von einer seriellen Datenübertragung gemäß dem SSI-Verfahren aus, bei der wenigstens ein Slave vorgesehen ist, der die Datenbits eines von wenigstens einem Sensor erfassten Messwerts zur bitweisen seriellen Übertragung auf wenigstens einer Datenleitung zu einem Master bereitstellt, und bei welcher der Master einen Messwert vom Slave mittels eines auf wenigstens einer Taktleitung bereitgestellten Taktbursts anfordert, der mehrere Taktzyklen aufweist, deren Anzahl auf die Anzahl der zu übertragenden Datenbits abgestimmt ist. Die erfindungsgemäße Messwert-Übertragungsvorrichtung zeichnet sich dadurch aus, dass die Taktzyklen des Taktbursts ein vorgegebenes Tastverhältnis aufweisen, welches dem Verhältnis von Impulsdauer zur Periodendauer eines Taktzyklus entspricht, dass der Master einen Vergleicher enthält, dass der Master die auf der wenigstens einen Taktleitung ausgegebenen Taktbursts zurückliest und das Tastverhältnis im Vergleicher auf das Überschreiten eines oberen Schwellenwerts und/oder das Unterschreiten eines unteren Schwellenwerts überprüft.

Die erfindungsgemäße Messwert-Übertragungsvorrichtung erhöht die Sicherheit der Datenübertragung durch ein Erkennen von Fehlern des vom Master ausgegebenen Taktsignals. Störimpulse, welche sich dem Taktsignal überlagern, können im Slave dazu führen, dass ein Taktzyklus oder sogar mehrere Taktzyklen zu viel detektiert werden. Störimpulse, mit denen insbesondere in einer industriellen Fertigung gerechnet werden muss, können beispielsweise durch elektromagnetische Beeinflussung der Taktleitungen verursacht sein die von hohen Strömen und Stromänderungen ausgehen können. Eine falsche Anzahl von Taktzyklen innerhalb eines Taktbursts hätte eine fehlerhafte Messwertübertragung zur Folge. Derartige Fehler bei der Messwertübertragung werden durch die erfindungsgemäßen Maßnahmen verhindert.

Der Master, der das Taktsignal selbst festlegt, überprüft auch selbst sein gerade bereitgestelltes Taktsignal auf die Einhaltung des vorgegebenen Tastverhältnisses, welches als das Verhältnis von der Impulsdauer zur Periodendauer eines Taktzyklus definiert sein soll. Hierbei kann entweder ein Lowpegel oder ein Highpegel als Impulsdauer bezeichnet werden. Im Folgenden wird ein Lowpegel als der aktive Signalpegel angesehen, sodass die Impulsdauer der Zeitdauer des Lowpegels entsprechen soll.

Eine andere erfindungsgemäße Messwert-Übertragungsvorrichtung geht ebenfalls von einer seriellen Datenübertragung gemäß dem SSI-Verfahren aus, bei der wenigstens ein Slave vorgesehen ist, der die Datenbits eines von wenigstens einem Sensor erfassten Messwerts zur bitweisen seriellen Übertragung auf wenigstens einer Datenleitung zu einem Master bereitstellt, und bei welcher der Master einen Messwert vom Slave mittels eines auf wenigstens einer Taktleitung bereitgestellten Taktbursts anfordert, der mehrere Taktzyklen aufweist, deren Anzahl auf die Anzahl der zu übertragenden Datenbits abgestimmt ist. Diese Messwert-Übertragungsvorrichtung zeichnet sich wieder dadurch aus, dass die Taktzyklen des Taktbursts ein vorgegebenes Tastverhältnis aufweisen, welches dem Verhältnis von Impulsdauer zur Periodendauer eines Taktzyklus entspricht, wobei hier jedoch der Slave einen Vergleicher enthält, in welchem der Slave das Tastverhältnis auf das Überschreiten eines oberen Schwellenwerts und/oder das Unterschreiten eines unteren Schwellenwerts überprüft.

Die Überprüfung des Tastverhältnisses auf die Einhaltung von wenigstens einer vorgegebenen Grenze erhöht auch hier die Sicherheit der Messwertübertragung durch ein Erkennen von Fehlern in Taktzyklen eines Taktbursts des wenigstens einen Taktsignals.

Vorzugsweise werden beide erfindungsgemäße Maßnahmen kombiniert, sodass sowohl der Vergleicher im Master als auch der Vergleicher im Slave zur Überprüfung des Tastverhältnisses vorgesehen sind. Hierdurch wird die Sicherheit insbesondere bei Messwert-Übertragungsvorrichtungen erhöht, bei denen der Master und die Slaves räumlich weit voneinander getrennt sind und dementsprechend relativ lange Taktleitungen erforderlich sind.

Ein wesentlicher Vorteil der erfindungsgemäßen Messwert-Übertragungsvorrichtung liegt darin, dass das eingangs beschriebene etablierte SSI-Verfahren beibehalten werden kann, sodass nur wenige Änderungen an der bekannten Hardware erforderlich ist.

Als Sensor der erfindungsgemäßen Messwert-Übertragungsvorrichtung ist bevorzugt ein magnetostriktiver Positions- beziehungsweise Geschwindigkeitssensor vorgesehen, der beispielsweise in der auf die Anmelderin zurückgehenden Patentschrift DE 10 2004 025 388 B4 näher beschrieben ist.

Vorteilhafte Ausgestaltungen und Weiterbildungen der erfindungsgemäßen Messwert-Übertragungsvorrichtungen sind Gegenstände von abhängigen Ansprüchen.

Ausführungsbeispiele der Erfindung sind in der Zeichnung dargestellt und in der nachfolgenden Beschreibung näher erläutert.

### Kurzbeschreibung der Figuren

Figur 1 zeigt ein Blockschaltbild einer erfindungsgemäßen Messwert-Übertragungsvorrichtung mit einem Master und einem Slave,
Figur 2 zeigt eine grundlegende Signalübertragung zwischen einem Master und einem Slave,
Figur 3 zeigt detailliert den in Figur 2 gezeigten Signalaustausch,
Figuren 4a bis 4c zeigen einen Signalaustausch zwischen einem Master und einem Slave, bei welchem ein Tastverhältnis eines Taktzyklus eines Taktbursts gestört ist,
Figur 5 zeigt ein Blockschaltbild einer anderen erfindungsgemäßen Messwert-Übertragungsvorrichtung mit einem Master und einem Slave und
Figuren 6a bis 6d zeigen einen Signalaustausch zwischen einem Master und einem Slave gemäß Figur 5, bei welchem ein Tastverhältnis eines Taktzyklus eines Taktbursts auf einer von zwei Taktleitungen gestört ist.

### Detaillierte Beschreibung der Ausführungsbeispiele

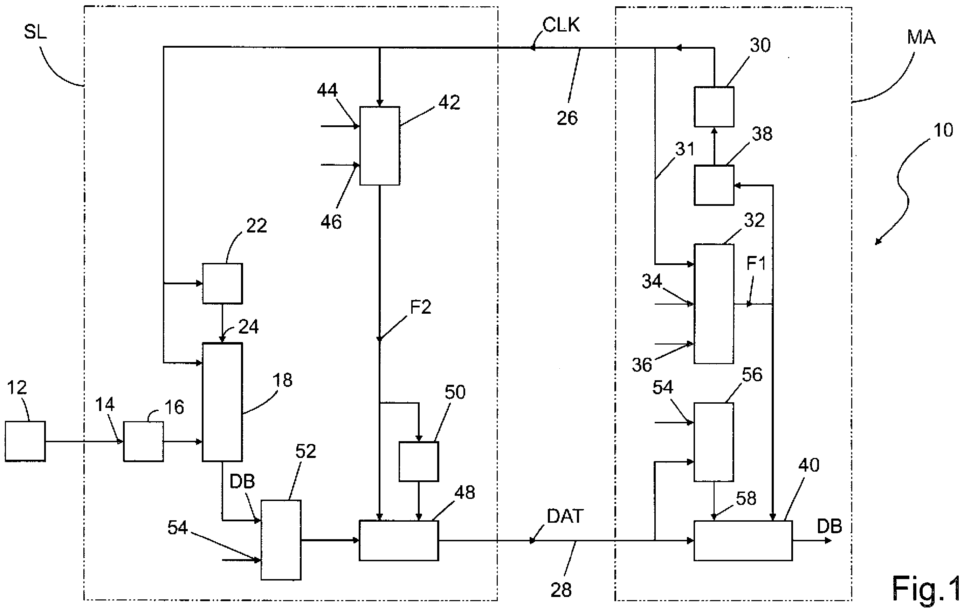

Figur 1 zeigt eine Messwert-Übertragungsvorrichtung 10, die einen Master MA und mindestens einen Slave SL enthält. Ein von einem Sensor 12 erfasster Messwert 14 wird vom Sensor 12 entweder analog oder bereits digitalisiert bereitgestellt. Im Fall einer Bereitstellung des Messwerts 14 als Analogsignal ist ein Analog/Digital-Umsetzer 16 vorgesehen, der entweder im Sensor 12 oder im Slave SL angeordnet ist. Der Messwert 14 wird in einer Daten-Bereithaltungsanordnung 18 hinterlegt und zur späteren Datenübertragung bereitgestellt.

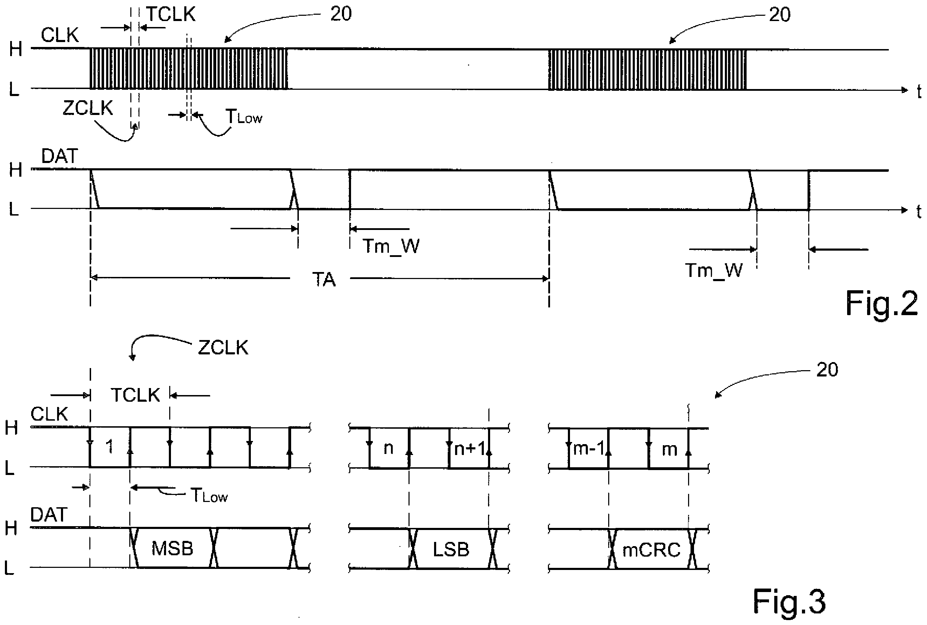

Die Messwertübertragung wird vom Master MA mittels eines Taktsignals CLK gesteuert. Zunächst fordert der Master MA mittels des Taktsignals CLK die Datenbits DB eines vom Slave SL bereitgestellten Messwerts 14 an. Das Taktsignal CLK ist in den Figuren 2 und 3 näher dargestellt. Zur Datenanforderung sendet der Master MA an den betreffenden Slave SL einen Taktburst 20 im Rahmen des Taktsignals CLK, welcher eine vorgegebene Anzahl von Taktzyklen ZCLK mit einer bestimmten Takt-Periodendauer TCLK aufweist. Die Anzahl der Taktzyklen ZCLK ist dem Slave SL bekannt. Das Tastverhältnis TLow/TCLK innerhalb einer Takt-Periodendauer TCLK, welches beispielsweise die Zeitdauer TLow des L-Pegels bezogen auf die Takt-Periodendauer TCLK angibt, ist fest vorgegeben und beispielsweise auf 50 % festgelegt.

Figur 2 zeigt einen Zeitabschnitt des Taktsignals CLK, der zwei Taktbursts 20 enthält, während Figur 3 die Signale detailliert zeigt, die während eines Taktbursts 20 auftreten. In Figur 2 ist die vorgegebene Anzahl von Taktzyklen ZCLK eines Taktbursts 20 aufgrund der Vielzahl von Taktzyklen ZCLK während eines Taktbursts 20 nur dicht gedrängt darstellbar.

Als Sensor 12 ist bevorzugt ein magnetostriktiver Positionssensor beziehungsweise Geschwindigkeitssensor vorgesehen, der beispielsweise in der bereits erwähnten Patentschrift DE 10 2004 025 388 B4 beschrieben ist, auf die Bezug genommen wird. Ein solcher Sensor 12 kann einen hoch aufgelösten Messwert 14 mit einer Datenbitbreite von beispielsweise 16 bit bis 48 bit bereitstellen. Hierbei kann der Messwert 14 eine Position oder auch eine Geschwindigkeit widerspiegeln, die aus der Position ermittelt werden kann.

Die Anzahl der Datenbits DB wird im Folgenden mit n bezeichnet. Für die Übertragung von n Datenbits DB werden bei der zugrundeliegenden synchronen seriellen Datenübertragung n+1 Taktzyklen ZCLK vorausgesetzt. Im Ruhezustand liegt das Taktsignal CLK beispielhaft auf dem Highpegel H. Während der Taktbursts 20 findet die Übertragung des Datensignals DAT statt, wobei die Datenbits DB im Rahmen des Datensignals DAT seriell Bit für Bit vom Slave SL zum Master MA übertragen werden. Auch hier wird beispielhaft vom Highpegel H des Datensignals DAT im Ruhezustand ausgegangen.

Die erste fallende Flanke des Taktsignals CLK zu Beginn eines Taktbursts 20 sorgt dafür, dass die Daten-Bereithaltungsanordnung 18 den vom Sensor 12 aktuell bereitgestellten, gegebenenfalls im Analog/Digital-Umsetzer 16 digitalisierten Messwert 14 speichert und für die folgende Messwertübertragung bereithält. Zur Steuerung der Daten-Bereithaltungsanordnung 18 ist ein Zeitgeber 22 vorgesehen, der mit der ersten fallenden Flanke des Taktsignals CLK getriggert wird. Das Auftreten des Schaltsignals 24 des Zeitgebers 22 veranlasst die Daten-Bereithaltungsanordnung 18 zur parallelen Übernahme des digital vorliegenden Messwerts 14 und zur Speicherung der Datenbits DB des Messwerts 14.

Die Bereitstellungsrate der einzelnen Messwerte 14 vom Sensor 12 kann erheblich von der Signalverarbeitung im Slave SL abweichen. Die Rate kann entweder langsamer oder schneller sein als die Takt-Periodendauer TCLK. Wesentlich ist nur, dass der aktuell vorliegende Messwert 14 mit einer Taktflanke, im Beispiel der ersten fallenden Taktflanke in der Daten-Bereithaltungsanordnung 18 gespeichert wird.

Mit der ersten steigenden Taktflanke des Taktsignals CLK stellt die Daten-Bereithaltungsanordnung 18 das erste Datenbit DB bereit. Vorzugsweise handelt es sich hierbei um das höchstwertige Bit (Most Significant Bit (MSB)). Mit jeder weiteren steigenden Taktflanke wird das nächste Datenbit DB bereitgestellt. Mit der vorletzten steigenden Taktflanke des Taktzyklus n+1 wird das niederwertigste Bit (Least Significant Bit (LSB)) bereitgestellt und zum Master MA übertragen.

Mit der letzten Taktflanke des Taktbursts 20 wird ein Wartesignal Tm_W bereitgestellt, während dem das Datensignal DAT einen vorgegebenen Pegel einnimmt. Im gezeigten Ausführungsbeispiel ist dies der Lowpegel. Anhand des Wartesignals Tm_W erkennt der Master MA einen Verrieglungszustand des Slaves SL und wartet entsprechend mit der Aussendung des nächsten Taktbursts 20. Die Wartezeit Tm_W kann daher auch als Verriegelungszeit bezeichnet werden. Die Wartezeit Tm_W signalisiert dem Master MA, dass der Slave SL noch nicht für eine weitere Übertragung der Datenbits DB eines neuen Messwerts 14 bereit ist. Die kurzzeitige Verriegelung der Messwertübertragung stellt sicher, dass im Slave SL die Datenbits DB eines definierten Messwerts 14 zu Beginn eines Taktbursts 20 gespeichert werden können.

Frühestens nach Ablauf der Wartezeit Tm_W fordert der Master MA die Datenbits DB eines neuen Messwerts 14 mittels eines neuen Taktbursts 20 an. Die Zeit von Taktburst zu Taktburst 20 ist in Figuren 2 als Abfragezeit TA eingetragen. Sofern eine periodische oder quasiperiodische Datenübertragung vom Master MA veranlasst wird, kann die Abfragezeit TA auch als Taktburst-Periodendauer bezeichnet werden. Der Master MA fordert vom Slave SL mit der Ausgabe des nächsten Taktbursts 20 die Übertragung der Datenbits DB eines neuen Messwerts 14 an.

Aufgrund der Arbeitsweise wird die Datenübertragung in der Messwert-Übertragungsvorrichtung 10 als synchrone serielle Datenübertragung beziehungsweise als "Synchronous Serial Interface (SSI)" bezeichnet, die etabliert ist, sodass sämtliche Master MA und Slaves SL verbunden werden können, die das SSI-Verfahren nutzen.

Dem Taktsignal CLK, das auf einer Taktleitung 26 vom Master MA zum Slave SL übertragen wird, kommt aufgrund des Funktionsprinzips erhebliche Bedeutung für eine ordnungsgemäße Datenübertragung zu. Wenn die Anzahl n der im Slave erwarteten Taktzyklen ZCLK nicht eintrifft oder wenn überzählige Taktzyklen ZCLK erkannt werden, wird das auf einer Datenleitung 28 übertragene Datensignal DAT im Master MA nicht richtig interpretiert und es liegt eine fehlerhafte Messwertübertragung vor.

Gemäß einer ersten Ausführung der Erfindung ist vorgesehen, dass das von einem Taktgenerator 30 im Master MA erzeugte Taktsignal CLK vom Master MA selbst zurückgelesen und bewertet wird. Das Zurücklesen bedeutet, dass der Master MA das von seinem Taktgenerator 30 erzeugte und an der Taktleitung 26 bereitgestellte Taktsignal CLK über eine Rückspeiseleitung 31 von der Taktleitung 26 wieder einliest und selbst bewertet. Das Taktsignal CLK wird über die Rückspeiseleitung 31 einem im Master MA angeordneten ersten Vergleicher 32 zugeführt. Der erste Vergleicher 32 bewertet das Tastverhältnis TLow/TCLK durch Vergleich mit einem oberen und/oder unteren Schwellenwert 34, 36.

Der wenigstens eine Schwellenwert 34, 36 ist beispielsweise derart festgelegt, dass eine Überschreitung des Tastverhältnisses TLow/TCLK von beispielsweise 10 % und entsprechendes Unterschreiten zu einem ersten Fehlersignal F1 führt, das beispielsweise einer Taktwiederholungsanordnung 38 und einer Datensignalfreigabe 40 zur Verfügung gestellt ist.

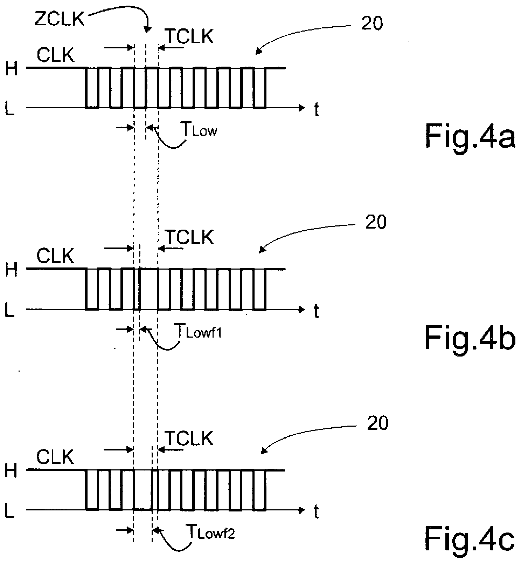

In Figur 4a ist von einem ordnungsgemäßen Tastverhältnis TLow/TCLK ausgegangen. Figur 4b zeigt ein fehlerhaftes Tastverhältnis TLowf1/TCLK, bei dem die Impulsdauer TLowf1 fehlerhafterweise zu kurz ist und demnach den unteren Schwellenwert 36 unterschreitet, während Figur 4c den Fall einer zu langen Impulsdauer TLowf2 zeigt, welche den oberen Schwellenwert 34 überschreitet.

Das erste Fehlersignal F1 veranlasst beispielsweise die Taktwiederholungsanordnung 38 zur erneuten Ausgabe des vom Fehler betroffenen Taktbursts 20. Vorzugsweise gleichzeitig wirkt das erste Fehlersignal F1 als Verriegelungssignal, welches die Datensignalfreigabe 40 in dem Sinne sperrt, dass das innerhalb des fehlerhaft erkannten Taktbursts 20 empfangene Datensignal DAT verworfen beziehungsweise die Ausgabe der empfangenen Datenbits DB gesperrt wird.

Das Zurücklesen des eigenen Taktsignals CLK und der Vergleich des Tastverhältnisses TLow/TCLK der Taktzyklen ZCLK des zurückgelesenen Taktburst 20 im ersten Vergleicher 32 mit dem oberen und/oder unteren Schwellenwert 34, 36 führt zu einer hohen Sicherheit bei der Messwertübertragung.

Gemäß einer zweiten Ausführung der Erfindung ist vorgesehen, dass im Slave SL ein zweiter Vergleicher 42 vorgesehen ist, der ebenfalls das Tastverhältnis TLow/TCLK der Taktzyklen ZCLK des Taktbursts 20 des Taktsignals CLK mit einem oberen und/oder unteren Schwellenwert 44, 46 vergleicht. Der wenigstens eine Schwellenwert 44, 46 kann identisch mit dem im Master MA vorgesehenen Schwellenwert 34, 36 sein. Der wenigstens eine Schwellenwert 44, 46 im Slave SL kann jedoch auch vom wenigstens einen Schwellenwert 34, 36 des Masters MA abweichen. Der im Master MA vorgesehene wenigstens eine Schwellenwert 34, 36 kann als masterbezogener Schwellenwert 34, 36 und der wenigstens eine im Slave SL vorgesehene Schwellenwert 44, 46 kann als slavebezogener Schwellenwert 44, 46 bezeichnet werden.

Der zweite Vergleicher gibt ein zweites Fehlersignal F2 aus, falls das Tastverhältnis TLow/TCLK einen Schwellenwert 44, 46 überschreitet/unterschreitet. Das zweite Fehlersignal F2 ist beispielsweise einer Datensignalaufbereitung 48 und gegebenenfalls einem Fehlersignalgenerator 50 zur Verfügung gestellt.

Die unterschiedlichen Fehlerfälle und deren Erkennung entsprechen denen, die bereits anhand der Figuren 4b und 4c erläutert wurden.

Das zweite Fehlersignal F2 veranlasst beispielsweise in der Datensignalaufbereitung 48 die Unterdrückung der Ausgabe der verbleibenden Datenbits DB in einem Taktburst 20, nachdem ein Fehler erkannt wurde.

Die Bewertung des Tastverhältnisses TLow/TCLK im zweiten Vergleicher 42 des Slaves SL durch Vergleich mit dem oberen und/oder unteren Schwellenwert 44, 46 stellt ebenfalls eine hohe Sicherheit bei der Messwertübertragung sicher.

Besonders zweckmäßig ist die Kombination der beiden erfindungsgemäßen Ausführungen, bei welcher im Master MA der erste Vergleicher 32 und im Slave SL der zweite Vergleicher 42 vorgesehen sind, wodurch eine weitere Erhöhung der Sicherheit bei der Messwertübertragung erzielt werden kann.

Eine Ausgestaltung sieht den Einsatz des bekannten CRC-Verfahrens vor, das bereits eingangs beschrieben wurde. Hierzu ist im Slave SL ein CRC-Generator 52 vorgesehen, der die seriell zur Verfügung stehenden Datenbits DB als ein Polynom betrachtet, welches durch ein vorgegebenes CRC-Generatorpolynom 54 dividiert wird. Der entstehende Rest der Division wird an die Datenbits DB als CRC-Prüfbits mCRC angehängt, wobei eine Anzahl m von CRC-Prüfbits mCRC vorgesehen sein soll. Aus Figur 3 ist ersichtlich, dass die CRC-Prüfbits mCRC an das LSB der Datenbits DB angehängt werden.

Der Master MA enthält eine CRC-Überprüfungsanordnung 56, welcher dasselbe CRC-Generatorpolynom 54 wie dem CRC-Generator 52 im Slave SL zur Verfügung gestellt ist. In der CRC-Überprüfungsanordnung 56 wird dieselbe Division durch das CRC-Generatorpolynom 54 mit sämtlichen empfangenen Bits, also den Datenbits DB und den CRC-Prüfbits mCRC durchgeführt. Aufgrund der Einbeziehung der übertragenen CRC-Prüfbits mCRC in die Division muss sich bei einer korrekten Übertragung der Wert null ohne Rest ergeben. Nur dann wurde die gesamte Bitfolge richtig übertragen. Insbesondere ergibt sich dann daraus, dass die Datenbits DB richtig an den Master MA übermittelt wurden. Nur in diesem Fall stellt die CRC-Überprüfungsanordnung 56 ein Freigabesignal 58 bereit, das der Datensignalfreigabe 40 signalisiert, dass die Datenbits DB gültig sind und zur weiteren Verarbeitung freigegeben werden können.

Als CRC-Generatorpolynom 54 sind vorzugsweise die Polynome 0xA412 oder 0xC86C oder 0xADC9 vorgesehen, entsprechend x¹⁶ + x¹⁴ + x¹¹ + x⁵ + x² + 1 oder x¹⁶ + x¹⁵ + x¹² + x⁷ + x⁶ + x⁴ + x³ + 1 oder x¹⁶ + x¹⁴ + x¹² + x¹¹ + x⁹ + x⁸ + x⁷ + x⁴ + x + 1.

Vorzugsweise werden 16 CRC-Prüfbits mCRC an die Datenbits DB angehängt.

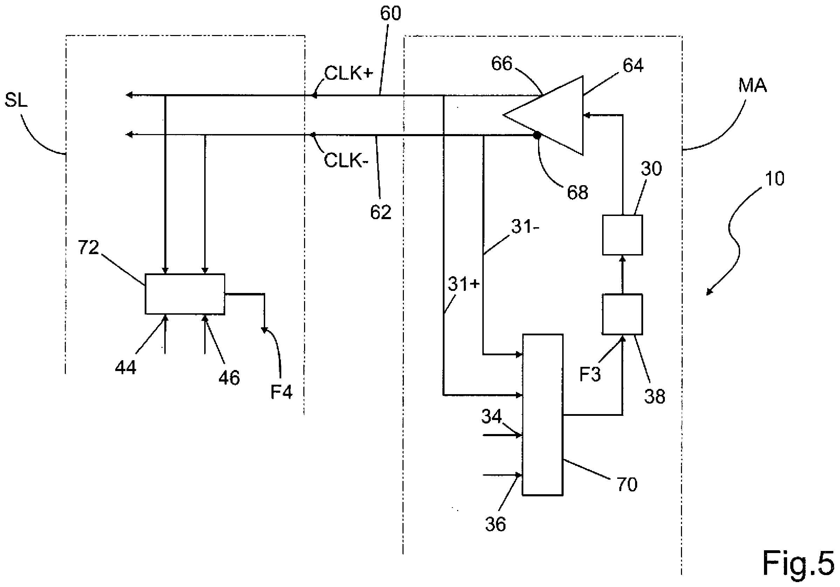

Eine weitere Erhöhung der Sicherheit wird dadurch erzielt, dass die in Figur 1 gezeigte Taktleitung 26 in zwei Taktleitungen 60, 62 aufgeteilt ist, auf denen ein differenzielles Taktsignal CLK+, CLK- übertragen wird. Ein Ausführungsbeispiel ist in Figur 5 gezeigt. Der Master MA enthält einen Bustreiber 64, der einen nicht invertierten Ausgang 66 sowie einen invertierten Ausgang 68 aufweist, wobei am nicht invertierten Ausgang 66 das erste Taktsignal CLK+ mit ersten Taktbursts 20+ und am invertierten Ausgang 68 das zweite Taktsignal 62 mit zweiten Taktbursts 20- ausgegeben werden soll.

Zumindest eines der beiden differenziellen Taktsignale CLK+, CLK-, vorzugsweise beide Signale CLK+, CLK- werden auch bei diesem Ausführungsbeispiel vom Master MA zurückgelesen und das Tastverhältnis TLow+/TCLK+, TLow-/TCLK- der Taktzyklen ZCLK+, ZCLK- der Taktbursts 20+, 20- wenigstens eines differenziellen Taktsignals CLK+, CLK- in einem dritten Vergleicher 70 mit dem wenigstens einen Schwellenwert 34, 36 verglichen. Das Zurücklesen bedeutet auch hier, dass wenigstens eines der an den Taktleitungen 60, 62 vom Master MA bereitgestellten Taktsignale CLK+, CLK- über wenigstens eine Rückspeiseleitung 31+, 31- sofort wieder eingelesen und dem dritten Vergleicher 70 zugeführt wird. Vorzugsweise sind auch hier der obere und der untere Schwellenwert 34, 36 vorgesehen, mit denen das Tastverhältnis TLow+/TCLK+, TLow-/TCLK- wenigstens eines differenziellen Taktsignals CLK+, CLK-, vorzugsweise beider differenziellen Taktsignale CLK+, CLK-, verglichen werden. Bei einer Schwellenüberschreitung beziehungsweise Schwellenunterschreitung wird ein drittes Fehlersignal F3 bereitgestellt, welcher wieder der Taktwiederholungsanordnung 38 zur Verfügung gestellt wird, die den Taktgenerator 30 zur erneuten Ausgabe eines Taktbursts 20+, 20- veranlasst. Auch die weitere Signalverarbeitung im Master MA kann entsprechend der bereits im Zusammenhang mit der in Figur 1 dargestellten Ausgestaltung der erfindungsgemäßen Messwert-Übertragungsvorrichtung 10 realisiert sein.

Entsprechend können gemäß der zweiten Ausführungsform der erfindungsgemäßen Messwert-Übertragungsvorrichtung 10 wieder im Slave SL das Tastverhältnis TLow+/TCLK+, TLow-/TCLK- der Taktzyklen ZCLK+, ZCLK- der Taktbursts 20+, 20- wenigstens eines differenziellen Taktsignals CLK+, CLK- in einem vierten Vergleicher 72 mit wenigstens einem Schwellenwert 44, 46 verglichen werden, der im Fehlerfall ein viertes Fehlersignal F4 bereitstellt. Die weitere Signalverarbeitung im Slave SL kann entsprechend der bereits im Zusammenhang mit der in Figur 1 dargestellten Ausgestaltung der erfindungsgemäßen Messwert-Übertragungsvorrichtung 10 realisiert sein.

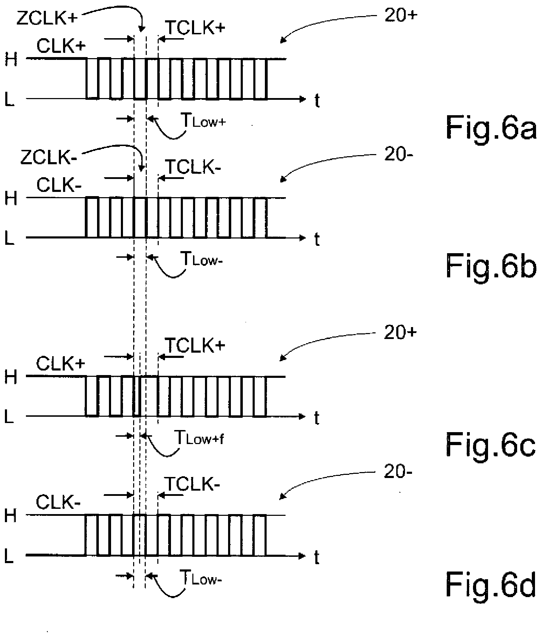

Teile von Taktbursts 20+, 20- der beiden differenziellen Taktsignale CLK+, CLKsind in den Figuren 6a und 6b gezeigt. Hierbei werden wieder exemplarisch die Lowpegel für die Bildung der Tastverhältnisse TLow+/TCLK+, TLow-/TCLK- herangezogen. Weiterhin soll trotz des invertierten Ruhepegels des zweiten differenziellen Taktsignals CLK- vom Lowpegel TLow- gesprochen werden.

Im gezeigten Ausführungsbeispiel soll gemäß Figur 6c nur im ersten differenziellen Taktsignal CLK+ zumindest ein fehlerhaftes Tastverhältnis TLow+f/TCLK+ in einem ersten Taktburst 20+ aufgetreten sein, welches beispielsweise den unteren Schwellenwert 36, 46 im Master MA und/oder im Slave SL unterschritten hat.

Exemplarisch wird gemäß Figur 6d davon ausgegangen, dass die Impulsdauern TLow- der Taktzyklen ZCLK- des zweiten Taktbursts 20- des zweiten differenziellen Taktsignals CLK- und damit die Tastverhältnisse TLow-/TCLK- während des zweiten Taktbursts 20- fehlerfrei geblieben sind. Obwohl in diesem Fall kein Schwellenwert 34, 36, 44, 46 über- beziehungsweise unterschritten wurde, wird in diesem Fall dennoch das dritte und/oder vierte Fehlersignal F3, F4 vom dritten beziehungsweise vierten Vergleicher 70, 72 bereitgestellt, weil ein Tastverhältnis TLow+f/TCLK zumindest eines Taktzyklus ZCLK+ eines ersten Taktbursts 20+ des ersten differenziellen Taktsignals CLK+ als fehlerhaft erkannt wurde.

## Patentansprüche

1. Messwert-Übertragungsvorrichtung zur seriellen Datenübertragung von wenigstens einem Slave (SL), der die Datenbits (DB) eines von wenigstens einem Sensor (12) erfassten Messwerts (14) zur bitweisen seriellen Übertragung auf wenigstens einer Datenleitung (28) zu einem Master (MA) bereitstellt und bei welcher der Master (MA) einen Messwert (14) vom Slave (SL) mittels eines auf wenigstens einer Taktleitung (26, 60, 62) bereitgestellten Taktbursts (20, 20+, 20-) anfordert, der mehrere Taktzyklen (ZCLK, ZCLK+, ZCLK-) aufweist, deren Anzahl (n+1) auf die Anzahl (n) der zu übertragenden Datenbits (DB) abgestimmt ist, **dadurch gekennzeichnet, dass** die Taktzyklen (ZCLK, ZCLK+, ZCLK-) des Taktbursts (20, 20+, 20-) ein vorgegebenes Tastverhältnis (TLow/TCLK, TLow+/TCLK+, TLow-/TCLK-) aufweisen, welches dem Verhältnis von Impulsdauer (TLow, TLow+, TLow-) zur Periodendauer (TCLK, TCLK+, TCLK-) eines Taktzyklus (ZCLK, ZCLK+, ZCLK-) entspricht, dass der Master (MA) einen Vergleicher (32, 70) enthält, dass der Master (MA) die auf der wenigstens einen Taktleitung (26, 60, 62) ausgegebenen Taktbursts (20, 20+, 20-) zurückliest und das Tastverhältnis (TLow/TCLK, TLow+/TCLK+, TLow-/TCLK-) im Vergleicher (32, 70) auf das Überschreiten eines oberen Schwellenwerts (34) und/oder das Unterschreiten eines unteren Schwellenwerts (36) überprüft.

2. Messwert-Übertragungsvorrichtung zur seriellen Datenübertragung von wenigstens einem Slave (SL), der die Datenbits (DB) eines von wenigstens einem Sensor (12) erfassten Messwerts (14) zur bitweisen seriellen Übertragung auf wenigstens einer Datenleitung (28) zu einem Master (MA) bereitstellt und bei welcher der Master (MA) einen Messwert (14) vom Slave (SL) mittels eines auf wenigstens einer Taktleitung (26, 60, 62) bereitgestellten Taktbursts (20, 20+, 20-) anfordert, der mehrere Taktzyklen (ZCLK, ZCLK+, ZCLK-) aufweist, deren Anzahl (n+1) auf die Anzahl (n) der zu übertragenden Datenbits (DB) abgestimmt ist, wobei die Taktzyklen (ZCLK, ZCLK+, ZCLK-) des Taktbursts (20, 20+, 20-) ein vorgegebenes Tastverhältnis (TLow/TCLK, TLow+/TCLK+, TLow-/TCLK-) aufweisen, welches dem Verhältnis von Impulsdauer (TLow, TLow+, TLow-) zur Periodendauer (TCLK, TCLK+, TCLK-) eines Taktzyklus (ZCLK, ZCLK+, ZCLK-) entspricht, **dadurch gekennzeichnet, dass** der Slave (SL) einen Vergleicher (42, 72) enthält und das Tastverhältnis (TLow/TCLK, TLow+/TCLK+, TLow-/TCLK-) im Vergleicher (42, 72) auf das Überschreiten eines oberen Schwellenwerts (44) und/oder das Unterschreiten eines unteren Schwellenwerts (46) überprüft und dass der Slave (SL) einen Fehlersignalgenerator (50) enthält, welcher beim Überschreiten oder Unterschreiten eine Fehlerdatenbitfolge zur seriellen Übertragung an den Master (MA) bereitstellt

3. Messwert-Übertragungsvorrichtung nach Anspruch 1, **dadurch gekennzeichnet, dass** zwei Taktleitungen (60, 62) vorgesehen sind, über welche erste und zweite Taktbursts (20+, 20-) als differenzielle Taktbursts (20+, 20-) mittels eines nicht invertierten und eines invertierten Taktbursts (20+, 20-) übertragen werden, dass der im Master (MA) enthaltene Vergleicher (32, 70) die korrespondierenden Tastverhältnisse (TLow+/TCLK+, TLow-/TCLK-) der Taktzyklen (ZCLK+, ZCLK-) des nicht invertierten und/oder des invertierten Taktbursts (20+, 20-) auf das Überschreiten des oberen Schwellenwerts (34) und/oder das Unterschreiten des unteren Schwellenwerts (36) überprüft.

4. Messwert-Übertragungsvorrichtung nach Anspruch 2, **dadurch gekennzeichnet, dass** zwei Taktleitungen (60, 62) vorgesehen sind, über welche erste und zweite Taktbursts (20+, 20-) als differenzielle Taktbursts (20+, 20-) mittels eines nicht invertierten und eines invertierten Taktbursts (20+, 20-) übertragen werden, dass der im Slave (SL) enthaltene Vergleicher (42, 72) die Tastverhältnisse (TLow+/TCLK+, TLow-/TCLK-) der Taktzyklen (ZCLK+, ZCLK-) des nicht invertierten und/oder des invertierten Taktbursts (20+, 20-) auf das Überschreiten des oberen Schwellenwerts (44) und/oder das Unterschreiten des unteren Schwellenwerts (46) überprüft.

5. Messwert-Übertragungsvorrichtung nach Anspruch 1 oder 3, **dadurch gekennzeichnet, dass** der Master (MA) eine Takt-Wiederholungsanordnung (38) enthält, welche bei einem festgestellten Fehler die Wiederholung der Ausgabe des Taktbursts (20, 20+, 20-) veranlasst.

6. Messwert-Übertragungsvorrichtung nach Anspruch 1, **dadurch gekennzeichnet, dass** der Master (MA) eine Datensignalfreigabe (40) enthält, welche bei einem festgestellten Fehler das empfangene Datensignal (DAT) ungültig wertet.

7. Messwert-Übertragungsvorrichtung nach Anspruch 1 oder 2, **dadurch gekennzeichnet, dass** der Slave (SL) einen CRC-Generator (52) enthält, welche in Abhängigkeit von den Datenbits (DB) und einem vorgegebenen CRC-Generatorpolynom (54) CRC-Prüfbits (mCRC) ermittelt, die vor der Übertragung an den Master (MA) an die Datenbits (DA) angehängt werden.

8. Messwert-Übertragungsvorrichtung nach Anspruch 7, **dadurch gekennzeichnet, dass** 16 CRC-Prüfbits (mCRC) vorgesehen sind.

9. Messwert-Übertragungsvorrichtung nach Anspruch 7, **dadurch gekennzeichnet, dass** als Generatorpolynom (54) 0xA412 oder 0xC86C oder 0xADC9 vorgesehen entsprechend X¹⁶ + x¹⁴ + x¹¹ + x⁵ + x² + 1 oder X¹⁶ + x¹⁵ + x¹² + x⁷ + x⁶ + x⁴ + x³ + 1 oder X¹⁶ + x¹⁴ + x¹² + x¹¹ + x⁹ + x⁸ + x⁷ + x⁴ + x + 1.

10. Messwert-Übertragungsvorrichtung nach Anspruch 7, **dadurch gekennzeichnet, dass** der Master (MA) eine CRC-Überprüfungsanordnung (56) enthält, welche in Abhängigkeit vom Polynom (54), den empfangenen Datenbits (DA) und den empfangenen CRC-Prüfbits (mCRC) die CRC-Prüfung vornimmt.

11. Messwert-Übertragungsvorrichtung nach Anspruch 1 oder 2, **dadurch gekennzeichnet, dass** als Sensor (12) ein magnetostriktiver Positions- oder Geschwindigkeitssensor vorgesehen ist.

## Claims

1. Measurement transfer device for serial data transfer from at least one slave (SL), which provides the data bits (DB) of a measurement (14) detected by at least one sensor (12) for bit-by-bit serial transfer on at least one data line (28) to a master (MA) and in which the master (MA) requests a measurement (14) from the slave (SL) by means of a clock burst (20, 20+, 20-) provided on at least one clock line (26, 60, 62), said clock burst (20, 20+, 20-) having several clock cycles (ZCLK, ZCLK+, ZCLK-), whose number (n+1) is adjusted to the number (n) of data bits (DB) to be transferred, **characterised in that** the clock cycles (ZCLK, ZCLK+, ZCLK-) of the clock burst (20, 20+, 20-) have a predetermined pulse duty factor (TLow/TCLK, TLow+/TCLK+, TLow-/TCLK-) which corresponds to the ratio of impulse duration (TLow, TLow+, TLow-) to period duration (TCLK, TCLK+, TCLK-) of one clock cycle (ZCLK, ZCLK+, ZCLK-), the master (MA) contains a comparator (32, 70), the master (MA) reads back the clock burst (20, 20+, 20-) emitted on the at least one clock line (26, 60, 62) and the pulse duty factor (TLow/TCLK, TLow+/TCLK+, TLow-/TCLK-) in the comparator (32, 70) checks for an upper threshold (34) being exceeded and/or a lower threshold (36) being fallen below.

2. Measurement transfer device for serial data transfer from at least one slave (SL), which provides the data bits (DB) of a measurement (14) detected by at least one sensor (12) for bit-by-bit serial transfer on at least one data line (23) to a master (MA) and in which the master (MA) requests a measurement (14) from the slave (SL) by means of a clock burst (20, 20+, 20-) provided on at least one clock line (26, 60, 62), said clock burst (20, 20+, 20-) having several clock cycles (ZCLK, ZCLK+, ZCLK-), whose number (n+1) is adjusted to the number (n) of data bits (DB) to be transferred, wherein the clock cycles (ZCLK, ZCLK+, ZCLK-) of the clock burst (20, 20+, 20-) have a predetermined pulse duty factor (TLow/TCLK, TLow+/TCLK+, TLow-/TCLK-) which corresponds to the ratio of impulse duration (TLow, TLow+, TLow-) to period duration (TCLK, TCLK+, TCLK-) of one clock cycle(ZCLK, ZCLK+, ZCLK-), **characterised in that** the slave (SL) contains a comparator (42, 72) and the pulse duty factor (TLow/TCLK, TLow+/TCLK+, TLow-/TCLK-) in the comparator (42, 72) checks for an upper threshold (44) being exceeded and/or a lower threshold (46) being fallen below, and the slave (SL) contains an error signal generator (50), which provides an error data bit sequence for serial transfer to the master (MA) upon exceeding or falling below.

3. Measurement transfer device according to claim 1, **characterised in that** two clock lines (60, 62) are provided, via which first and second clock bursts (20+, 20-) are transferred as differential clock bursts (20+, 20-) by means of a non-inverted and an inverted clock burst (20+, 20-), the comparator (32, 70) contained in the master (MA) checks the corresponding pulse duty factors (TLow+/TCLK+, TLow-/TCLK-) of the clock cycles (ZCLK+, ZCLK-) of the non-inverted and/or of the inverted clock burst (20+, 20-) for the upper threshold (34) being exceeded and/or the lower threshold (36) being fallen below.

4. Measurement transfer device according to claim 2, **characterised in that** two clock lines (60, 62) are provided, via which first and second clock bursts (20+, 20-) are transferred as differential clock bursts (20+, 20-) by means of a non-inverted and an inverted clock burst (20+, 20-), the comparator (42, 72) contained in the slave (SL) checks the pulse duty factors (TLow+/TCLK+, TLow-/TCLK-) of the clock cycles (ZCLK+, ZCLK-) of the non-inverted and/or of the inverted clock burst (20+, 20-) for the upper threshold (44) being exceeded and/or the lower threshold (46) being fallen below.

5. Measurement transfer device according to claim 1 or 3, **characterised in that** the master (MA) contains a clock repetition arrangement (38) which, upon determining an error, induces the repetition of the output of the clock burst (20, 20+, 20-).

6. Measurement transfer device according to claim 1, **characterised in that** the master (MA) contains a data signal release (40) which, upon determining an error, classifies the received data signal (DAT) invalid.

7. Measurement transfer device according to claim 1 or 2, **characterised in that** the slave (SL) contains a CRC generator (52) which, depending on the data bits (DB) and a predetermined CRC generator polynomial, detects CRC parity bits (mCRC) which are attached to the data bits (DA) before transferring to the master (MA).

8. Measurement transfer device according to claim 7, **characterised in that** 16 CRC parity bits (mCRC) are provided.

9. Measurement transfer device according to claim 7, **characterised in that** 0xA412 or 0xC86C or 0xADC9 are provided as the generator polynomial (54), correspondingly x¹⁶ + x¹⁴ + x¹¹ + x⁵ + x² + 1 or x¹⁶ + x¹⁵ + x¹² + x⁷ + x⁶ + x⁴ + x³ +1 or x¹⁶ + x¹⁴ + x¹² + x¹¹ + x⁹ + x⁸ + x⁷ + x⁴ + x +1.

10. Measurement transfer device according to claim 7, **characterised in that** the master (MA) contains a CRC checking arrangement (56) which, depending on the polynomial (54), the received data bits (DA) and the received parity bits (mCRC), undertakes the CRC testing.

11. Measurement transfer device according to claim 1 or 2, **characterised in that** a magneto-strictive position or speed sensor is provided as the sensor (12).

## Revendications

1. Dispositif de transmission de valeurs de mesure pour permettre la transmission en série de données d'au moins un esclave (SL) qui fournit à un maître (MA) les bits de données (DB) d'une valeur de mesure (14) détectée par au moins un capteur (12) pour permettre la transmission en série bit par bit sur au moins une ligne de données (28), et dans lequel le maître (MA) demande une valeur de mesure (14) à l'esclave (SL) au moyen d'une salve d'horloge (20, 20+, 20-) fournie sur au moins une ligne d'horloge (26, 60, 62), qui comporte plusieurs cycles d'horloge (ZCLK, ZCLK+, ZCLK-) dont le nombre (n+1) est accordé au nombre (n) des bits de données (DB) à transmettre,
**caractérisé en ce que**
les cycles d'horloge (ZCLK, ZCLK+, ZCLK-) de la salve d'horloge (20, 20+, 20-) présentent un facteur d'utilisation prédéfini (TLow/TCLK, TLow+/TCLK+, TLow-/TCLK-), qui correspond au rapport de la durée d'impulsion (TLow, TLow+, TLow-) à la durée de la période (TCLK, TCLK+, TCLK-) d'un cycle d'horloge (ZCLK, ZCLK+, ZCLK-), le maître (MA) comprend un comparateur (32, 70), le maître (MA) relit les salves d'horloge (20, 20+, 20-) délivrées sur la ligne d'horloge (26, 60, 62) et contrôle le facteur d'utilisation (TLow-/TLCK, TLow+/TCLK+, TLow-/TCLK-) dans le comparateur (32, 70) pour déterminer le dépassement d'une valeur de seuil supérieure (34) et/ou le passage au-dessous d'une valeur de seuil inférieure (36).

2. Dispositif de transmission de valeurs de mesure pour permettre la transmission en série de données d'au moins un esclave (SL) qui fournit à un maître (MA) les bits de données (DB) d'une valeur de mesure (14) détectée par au moins un capteur (12) pour permettre la transmission en série bit par bit sur au moins une ligne de données (28), et dans lequel le maître (MA) demande une valeur de mesure (14) à l'esclave (SL) au moyen d'une salve d'horloge (20, 20+, 20-) fournie sur au moins une ligne d'horloge (26, 60, 62) qui comprend plusieurs cycles d'horloge (ZCLK, ZCLK+, ZCLK-) dont le nombre (n+1) est accordé au nombre (n) des bits de données (DB) à transmettre, les cycles d'horloge (ZCLK, ZCLK+, ZCLK-) de la salve d'horloge (20, 20+, 20-) ayant un facteur d'utilisation prédéfini (TLow/TCLK, TLow+/TCLK+, TLow-/TCLK-), qui correspond au rapport de la durée d'impulsion (TLow, TLow+, TLow-) à la durée de la période (TCLK, TCLK+, TCLK-) d'un cycle d'horloge (ZCLK, ZCLK+, ZCLK-),
**caractérisé en ce que**
l'esclave (SL) comprend un comparateur (42, 72) et contrôle le facteur d'utilisation (TLow/TCLK, TLow+/TCLK+, TLow-/TCLK-) dans le comparateur (42, 72) pour déterminer le dépassement d'une valeur de seuil supérieure (44) et/ou le passage au-dessous d'une valeur de seuil inférieure (46), et l'esclave (SL) renferme un générateur de signaux de défaut (50) qui, en présence d'un dépassement ou d'un passage au-dessous de la valeur de seuil fournit une succession de bits de données de défaut pour permettre leur transmission en série au maître (MA).

3. Dispositif de transmission de valeurs de mesure conforme à la revendication 1,
**caractérisé en ce qu'**
il est prévu deux lignes d'horloge (60, 62) sur lesquelles sont transmises des premières et des secondes salves d'horloge (20+, 20-) en tant que salves d'horloge différentielles (20+, 20-) au moyen d'une salve d'horloge non inversée et d'une salve d'horloge inversée (20+, 20-) et, le comparateur (32, 70) contenu dans le maître (MA) contrôle les facteurs d'utilisation correspondants (TLow+/TCLK+, TLow-/TCLK-) des cycles d'horloge (ZCLK+, ZCLK-) de la salve d'horloge non inversée et/ou de la salve d'horloge inversée (20+, 20-) pour déterminer le dépassement de la valeur de seuil supérieure (34) et/ou le passage en dessous de la valeur de seuil inférieure (36).

4. Dispositif de transmission de valeurs de mesure conforme à la revendication 2,
**caractérisé en ce qu'**
il est prévu deux lignes d'horloge (60, 62) sur lesquelles sont transmis des premières salves d'horloge et des secondes salves d'horloge (20+, 20-) en tant que salves d'horloge différentielles (20+, 20-) au moyen d'une salve d'horloge non inversée et d'une salve d'horloge inversée (20+, 20-), et, le comparateur (42, 72) contenu dans l'esclave (SL) contrôle le facteur d'utilisation (TLow+/TCLK+, TLow-/TCLK-) des cycles d'horloge (ZCLK+, ZCLK-) de la salve d'horloge non inversée et/ou de la salve d'horloge inversée (20+, 20-) pour déterminer le dépassement de la valeur de seuil supérieure (44) et/ou le passage au-dessous de la valeur de seuil inférieure (46).

5. Dispositif de transmission de valeurs de mesure conforme à la revendication 1 ou 3,
**caractérisé en ce que**
le maître (MA) comprend un dispositif de répétition d'horloge (38) qui, en présence de la détermination d'un défaut provoque la répétition de la délivrance de la salve d'horloge (20, 20+,20-).

6. Dispositif de transmission de valeurs de mesure conforme à la revendication 1,
**caractérisé en ce que**
le maître (MA) comprend un élément de libération de signaux de données (40) qui, en présence de la détermination d'un défaut considère, comme non valable, le signal de données reçu (DAT).

7. Dispositif de transmission de valeurs de mesure conforme à la revendication 1 ou 2,
**caractérisé en ce que**
l'esclave (SL) comprend un générateur CRC (52) qui détermine, en fonction des bits de données (DB) et d'un polynôme (54) du générateur CRC prédéfini des bits de contrôle CRC (mCRC) qui sont adjoints aux bits de données (DA) avant leur transmission au maître (MA).

8. Dispositif de transmission de valeurs de mesure conforme à la revendication 7,
**caractérisé en ce qu'**
il est prévu 16 bits de contrôle CRC (mCRC).

9. Dispositif de transmission de valeurs de mesure conforme à la revendication 7,
**caractérisé en ce qu'**
en tant que polynôme (54) du générateur sont prévus des polynômes 0xA412 ou 0xC86C ou 0xADC9 correspondant à x¹⁶+x¹⁴+x¹¹+x⁵+x²+1 ou x¹⁶+x¹⁵+x¹²+x⁷+x⁶+x⁴+x³+1 ou x¹⁶+x¹⁴+x¹²+x¹¹+x⁹+x⁸+x⁷+x⁴+x+1.

10. Dispositif de transmission de valeurs de mesure conforme à la revendication 7,
**caractérisé en ce que**
le maître (MA) comprend une installation de contrôle CRC (56) qui, effectue le contrôle CRC en fonction du polynôme (54), des bits de données (DA) reçus et des bits de contrôle CRC (mCRC) reçus.

11. Dispositif de transmission de valeurs de mesure conforme à la revendication 1 ou 2,
**caractérisé en ce qu'**
en tant que capteur (12), il est prévu un capteur de vitesse ou un capteur de position magnétostrictif.
